# EUROPEAN PATENT APPLICATION

(11) **EP 4 663 810 A1**
(43) Date of publication of application: **17.12.2025**
(21) Application number: 25182306.8
(22) Date of filing: 12.06.2025
(51) Int. Cl.: C23C 28/04, C23C 16/30, C23C 16/34, C23C 16/36, C23C 16/38, C23C 16/40, C23C 30/00

(54) **COATED CUTTING TOOL**

(30) Priority: 14.06.2024 JP 2024096610
(71) Applicant: Tungaloy Corporation, Iwaki-shi, Fukushima 970-1144 (JP)
(72) Inventor: SHIROCHI, Tsukasa, Iwaki-shi, Fukushima 970-1144 (JP)
(74) Representative: Vossius & Partner Patentanwälte Rechtsanwälte mbB

(57) **Abstract**

A coated cutting tool comprising a substrate and a coating layer formed on a surface of the substrate, wherein the coating layer comprises a lower layer, an intermediate layer, and an upper layer layered in this order from the substrate side to the surface side of the coating layer, the lower layer comprises a specific Ti compound layer, the intermediate layer comprises an α-Al₂O₃ layer, the upper layer comprises a specific Ti compound layer, an average thickness of the entire coating layer is 10.0 µm or more and 25.0 µm or less, an average thickness of the upper layer is 1.2 µm or more and 6.0 µm or less, and a proportion of a length of a Σ11 grain boundary to a length of a CSL grain boundary of 100% in the upper layer is 25% or more.

## Description

### Technical Field

The present invention relates to a coated cutting tool.

### Background Art

It is well known to use a coated cutting tool in which a coating layer having a total thickness of 3 µm to 20 µm is formed by a chemical vapor deposition method on the surface of a substrate composed of a cemented carbide, for cutting steel, cast iron, and the like. Known examples of the above-mentioned coating layer include a coating layer consisting of a single layer of one kind selected from the group consisting of a Ti carbide, nitride, carbonitride, oxycarbide and oxycarbonitride, and aluminum oxide, or consisting of multiple layers of two or more kinds selected from the foregoing.

For example, Japanese Patent Laid-Open No. 2020-37150 describes a coated cutting tool comprising a substrate and a coating layer formed on a surface of the substrate, wherein the coating layer comprises a lower layer, an intermediate layer, and an upper layer in this order from the substrate side to the surface side of the coating layer, the lower layer comprises one or two or more Ti compound layers containing a Ti compound of Ti and at least one element selected from the group consisting of C, N, O and B, the intermediate layer contains α-Al₂O₃, the upper layer contains TiCN, an average thickness of the lower layer is 4.0 µm or more and 10.0 µm or less, an average thickness of the intermediate layer is 3.0 µm or more and 10.0 µm or less, an average thickness of the upper layer is 1.5 µm or more and 6.5 µm or less, a proportion of a length of a Σ3 grain boundary to the total length of all grain boundaries of 100% in a specific region of the upper layer is 20% or more and 60% or less, and a proportion of grains on a (111) plane of the upper layer is 30 area% or more.

For example, Japanese Patent Laid-Open No. 2009-142972 describes a surface coated cutting tool obtained by forming a hard coating layer comprising a Ti composite carbonitride layer having an average layer thickness of 1 to 10 µm on a surface of a tool substrate constituted of a tungsten carbide based cemented carbide, a titanium carbonitride based cermet, or a cubic boron nitride based ultrahigh pressure sintered material by vapor deposition, wherein
(a) the Ti composite carbonitride layer satisfies 0.2 ≤ X ≤ 0.5 (provided that, X represents an atomic ratio) when being represented by a composition formula: TiC_{X}N_{1-X},
(b) a distribution graph of the number of tilt angles obtained by individually irradiating each of crystal grains having a cubic lattice present within a measurement range of a polished surface with an electron beam using a field emission-scanning electron microscope, measuring tilt angles of each normal to a (100) plane as a crystal plane of each crystal grain to a normal to the polished surface, dividing the measured tilt angles within a range of 0 to 45 degrees among measured tilt angles into divisions with a 0.25-degree pitch, and summing up the number of degrees present within each division, has the maximum peak in a tilt angle division within a range of 0 to 10 degrees, wherein the proportion of the total number of degrees present within the range of 0 to 10 degrees in the total number of degrees in the distribution graph of the number of tilt angles is 60% or more, and
(c) when each of crystal grains having a cubic lattice present within a measurement range of a polished surface is irradiated with an electron beam using a field emission-scanning electron microscope; tilt angles of each normal to a (100) plane as a crystal plane of each crystal grain to a normal to the polished surface are measured, the crystal grain having a NaCl-type face-centered cubic crystal structure in which constituent atoms composed of Ti, carbon, and nitrogen are present on lattice points; based on the resulting measurement tilt angles, the distribution of lattice points where each of constituent atoms shares one constituent atom between crystal grains adjacent to each other (constituent atom-shared lattice points) is then calculated at an interface between crystal grains adjacent to each other; and a constituent atom-shared lattice point form in which N lattice points (N is an even number of 2 or more in view of a crystal structure of a NaCl-type face-centered cubic crystal) sharing no constituent atom are present between the constituent atom-shared lattice points is represented by ΣN + 1, a distribution graph of constituent atom-shared lattice points showing the distribution proportion of each ΣN + 1 in all ΣN + 1 (provided that the upper limit value of N is 28 in relation to frequency) has a sum of distribution proportions of Σ3, Σ5, Σ7, Σ9, Σ11, and Σ13 of 70% or more in the total distribution proportion of all ΣN + 1.

### Summary

### Technical Problem

The feed and cutting depth of cutting processes have significantly increased in recent times, which has created a demand for further improvement in wear resistance and fracture resistance of tools compared to those involved in the prior art. In particular, in machining under high-feed and high-cutting depth of steel conditions, the number of cutting in which a high load is exerted on a coating cutting tool has increased. Under severe cutting conditions as described above, cracks are easily occurred and propagated during cutting, and chipping due to this occurs in the conventional tools. This triggers a problem such that the tool life cannot be extended. Under such circumstances, the coated cutting tool described in Japanese Patent Laid-Open No. 2020-37150 is demanded to have further improved wear resistance and chipping resistance. Since the coated cutting tool described in Japanese Patent Laid-Open No. 2009-142972 comprises no α-Al₂O₃ layer containing α-aluminum oxide, the wear resistance is insufficient. In addition, the proportion of the length of the Σ11 grain boundary to the length of the CSL grain boundary is not examined or its proportion is not sufficiently high, and thus there is room for improvement in chipping resistance.

The present invention has been made in light of the above circumstances, and an object of the present invention is to provide a coated cutting tool which has excellent wear resistance and chipping resistance and which accordingly allows for an extended tool life.

### Solution to Problem

The present inventors have conducted extensive research on extending the tool life of a coated cutting tool from the above perspective, and have found that, when a coated cutting tool has a specific configuration, the occurrence and propagation of cracks during cutting are suppressed to achieve excellent chipping resistance and the adhesion between the intermediate layer and the upper layer is improved, which makes it possible to exhibit high wear resistance and chipping resistance over a long period in intermittent machining and high-feed machining of steel, and as a result, the tool life can be extended. The present invention has been accomplished based on this finding.

That is, the gist of the present invention is as follows.
[1] A coated cutting tool comprising a substrate and a coating layer formed on a surface of the substrate, wherein
   the coating layer comprises a lower layer, an intermediate layer, and an upper layer layered in this order from the substrate side to the surface side of the coating layer,
   the lower layer comprises a Ti compound layer containing a Ti compound of Ti and at least one element selected from the group consisting of C, N, O and B,
   the intermediate layer comprises an α-Al₂O₃ layer containing α-aluminum oxide,
   the upper layer comprises a Ti compound layer containing a Ti compound of Ti and at least one element selected from the group consisting of C, N, O and B,
   an average thickness of the entire coating layer is 10.0 µm or more and 25.0 µm or less,
   an average thickness of the upper layer is 1.2 µm or more and 6.0 µm or less, and
   a proportion of a length of a Σ11 grain boundary to a length of a CSL grain boundary of 100% in the upper layer is 25% or more.
[2] The coated cutting tool according to [1], wherein the proportion of the length of the Σ11 grain boundary is the maximum among proportions of a length of each Σn grain boundary (n is an odd number of 3 or more and 29 or less) to the length of the CSL grain boundary of 100% in the upper layer.
[3] The coated cutting tool according to [1] or [2], wherein the proportion of the length of the CSL grain boundary to a total length of all grain boundaries of 100% in the upper layer is 20% or more and 60% or less.
[4] The coated cutting tool according to any one of [1] to [3], wherein the upper layer comprises at least a TiCN layer and/or a TiCNO layer.
[5] The coated cutting tool according to any one of [1] to [4], wherein an average thickness of the intermediate layer is 3.0 µm or more and 15.0 µm or less.
[6] The coated cutting tool according to any one of [1] to [5], wherein an average thickness of the lower layer is 3.0 µm or more and 15.0 µm or less.
[7] The coated cutting tool according to any one of [1] to [6], wherein the substrate is composed of any of a cemented carbide, a cermet, a ceramic or a cubic boron nitride sintered body.

### Advantageous Effects of Invention

According to the present invention, it is possible to provide a coated cutting tool that has excellent wear resistance and chipping resistance, thereby making it possible to extend the tool life.

### Brief Description of Drawings

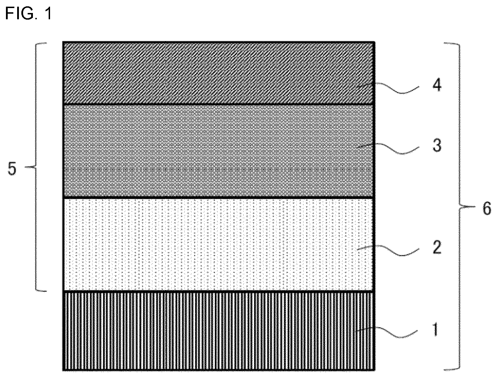

FIG. 1 is a schematic view showing an example of a coated cutting tool according to the present invention.

### Description of Embodiments

Hereinafter, a mode for carrying out the present invention (hereinafter, simply referred to as "the present embodiment") will be described in detail with reference to the drawings as necessary, but the present invention is not limited to the present embodiment described below. The present invention can be variously modified without departing from the gist thereof. In addition, in the drawings, positional relationships such as up, down, left, and right are based on the positional relationships shown in the drawings unless otherwise specified. Further, the dimensional ratios of the drawings are not limited to those shown therein.

A coated cutting tool of the present embodiment comprises a substrate and a coating layer formed on a surface of the substrate, wherein the coating layer comprises a lower layer, an intermediate layer, and an upper layer layered in this order from the substrate side to the surface side of the coating layer, the lower layer comprises a Ti compound layer containing a Ti compound of Ti and at least one element selected from the group consisting of C, N, O and B, the intermediate layer comprises an α-Al₂O₃ layer containing α-aluminum oxide, the upper layer comprises a Ti compound layer containing a Ti compound of Ti and at least one element selected from the group consisting of C, N, O and B, an average thickness of the entire coating layer is 10.0 µm or more and 25.0 µm or less, an average thickness of the upper layer is 1.2 µm or more and 6.0 µm or less, and a proportion of a length of a Σ11 grain boundary to a length of a CSL grain boundary of 100% in the upper layer is 25% or more.

The coated cutting tool of the present embodiment comprises the above-described configurations, and this allows the wear resistance and the chipping resistance of the coated cutting tool to be improved; as a result, the tool life thereof can be extended. The factors that improve the wear resistance and chipping resistance of the coated cutting tool of the present embodiment are considered hereinbelow. However, the present invention is not in any way limited by the factors set forth below. In other words, first, the coated cutting tool of the present embodiment contains a Ti compound layer containing a Ti compound of Ti and an element of at least one kind selected from the group consisting of C, N, O and B as the lower layer of the coating layer. When the coated cutting tool of the present embodiment includes such a lower layer between the substrate and the intermediate layer including the α-Al₂O₃ layer containing α-aluminum oxide, the wear resistance and adhesion are improved. In the coated cutting tool of the present embodiment, where the average thickness of the entire coating layer is 10.0 µm or more, the wear resistance is excellent. Meanwhile, where the average thickness of the entire coating layer is 25.0 µm or less, the adhesion of the coating layer is improved, so that the chipping resistance is excellent. In the coated cutting tool of the present embodiment, where the average thickness of the upper layer is 1.2 µm or more, the wear resistance is excellent. Meanwhile, where the average thickness of the upper layer is 6.0 µm or less, the adhesion of the coating layer is improved, so that the chipping resistance is excellent. In the coated cutting tool of the present embodiment, where the upper layer comprises a Ti compound layer containing a Ti compound of Ti and at least one element selected from the group consisting of C, N, O and B and the proportion of the length of the Σ11 grain boundary to the length of the CSL grain boundary of 100% in the upper layer is 25% or more, the occurrence and propagation of cracks during cutting are suppressed, so that the chipping resistance is excellent, and the adhesion between the intermediate layer and the upper layer is also improved, so that high wear resistance and chipping resistance are exhibited over a long period. The combining of the above configurations allows for the coated cutting tool of the present embodiment to have improved wear resistance and chipping resistance, and accordingly, it can be considered that the tool life can be extended.

FIG. 1 is a schematic cross-sectional view showing an example of the coated cutting tool of the present embodiment. A coated cutting tool 6 comprises a substrate 1 and a coating layer 5 formed on the surface of the substrate 1. In the coating layer 5, a lower layer 2, an intermediate layer 3, and an upper layer 4 are layered in this order in an upward direction.

The coated cutting tool of the present embodiment comprises a substrate and a coating layer formed on the surface of the substrate. Specific examples of the type of coated cutting tool include a cutting edge exchangeable cutting insert for milling or turning, a drill and an end mill.

The substrate used in the present embodiment is not particularly limited as long as it can be used as the substrate of the coated cutting tool. Examples of such a substrate include cemented carbides, cermets, ceramics, cubic boron nitride sintered bodies, diamond sintered bodies, and high-speed steels. From among the above examples, the substrate is preferably comprised of a cemented carbide, cermet, ceramic or a cubic boron nitride sintered body as this provides further excellent wear resistance and fracture resistance, and, from the same perspective, the substrate is more preferably comprised of a cemented carbide.

The surface of the substrate may be modified. For example, when the substrate is made of a cemented carbide, a β free layer may be formed on the surface thereof. Further, where the substrate is made of a cermet, a hardened layer may be formed on the surface thereof. The effects of the present invention can be obtained even if the surface of the substrate is modified as described above.

The average thickness of the entire coating layer used in the present embodiment is 10.0 µm or more and 25.0 µm or less. In the coated cutting tool of the present embodiment, where the average thickness of the entire coating layer is 10.0 µm or more, the wear resistance is excellent. Meanwhile, where the average thickness of the entire coating layer is 25.0 µm or less, the adhesion of the coating layer is improved, so that the chipping resistance is excellent. From the same viewpoint, the average thickness of the entire coating layer is preferably 10.5 µm or more and 24.5 µm or less, and more preferably 12.0 µm or more and 22.0 µm or less.

The average thickness of each layer and the entire coating layer in the coated cutting tool of the present embodiment can be determined by measuring the thickness of each layer or the thickness of the entire coating layer from the cross-section at three or more places in each layer or the entire coating layer and calculating the arithmetic mean value.

### Lower Layer

The lower layer used in the present embodiment includes a Ti compound layer containing a Ti compound of Ti and at least one element selected from the group consisting of C, N, O and B. When the coated cutting tool of the present embodiment includes such a lower layer between the substrate and the intermediate layer including the α-Al₂O₃ layer containing an α-aluminum oxide layer, the wear resistance and adhesion are improved.

Examples of the Ti compound layer in the lower layer include a TiC layer containing TiC, a TiN layer containing TiN, a TiCN layer containing TiCN, a TiCO layer containing TiCO, a TiCNO layer containing TiCNO, a TiON layer containing TiON, and a TiB₂ layer containing TiB₂.

The lower layer may be constituted of one layer or may be constituted of multiple layers (for example, two layers or three layers), but is preferably constituted of multiple layers, more preferably of two or three layers, and even more preferably of three layers. From the viewpoint of further improving the wear resistance and adhesion, the lower layer preferably includes at least one layer selected from the group consisting of a TiN layer, a TiC layer, a TiCN layer, a TiCNO layer, and a TiCO layer. In the coated cutting tool of the present embodiment, where at least one layer of the lower layer is a TiCN layer, the wear resistance tends to be further improved. In the coated cutting tool of the present embodiment, at least one layer of the lower layer is a TiN layer, and where the TiN layer is formed on a surface of the substrate, adhesion tends to be further improved. In the coated cutting tool of the present embodiment, at least one layer of the lower layer is a TiCNO layer, and where the TiCNO layer is formed so as to be in contact with the intermediate layer including the α-Al₂O₃ layer, adhesion tends to be further improved. When the lower layer is constituted by three layers: a TiC layer or a TiN layer, serving as a first layer, may be formed on a surface of the substrate; a TiCN layer, serving as a second layer, may be formed on a surface of the first layer; and a TiCNO layer or a TiCO layer, serving as a third layer, may be formed on a surface of the second layer. In particular, as to the lower layer: a TiN layer, serving as a first layer, may be formed on a surface of the substrate; a TiCN layer, serving as a second layer, may be formed on a surface of the first layer; and a TiCNO layer, serving as a third layer, may be formed on a surface of the second layer.

The average thickness of the lower layer used in the present embodiment is preferably 3.0 µm or more and 15.0 µm or less. In the coated cutting tool of the present embodiment, where the average thickness of the lower layer is 3.0 µm or more, the wear resistance tends to be excellent. Meanwhile, in the coated cutting tool of the present embodiment, where the average thickness of the lower layer is 15.0 µm or less, the adhesion of the coating layer is improved, so that the chipping resistance tends to be excellent. From the same viewpoint, the average thickness of the lower layer is more preferably 4.5 µm or more and 14.5 µm or less, even more preferably 5.5 µm or more and 13.0 µm or less.

In the lower layer used in the present embodiment, for example, from the viewpoint of further improving the wear resistance and fracture resistance, the average thickness of the TiC layer or the TiN layer is preferably 0.05 µm or more and 1.0 µm or less. From the same viewpoint, the average thickness of the TiC layer or the TiN layer is more preferably 0.10 µm or more and 0.5 µm or less, and even more preferably 0.15 µm or more and 0.3 µm or less.

In the lower layer used in the present embodiment, for example, from the viewpoint of further improving the wear resistance and fracture resistance, the average thickness of the TiCN layer is preferably 2.5 µm or more and 15.0 µm or less. From the same viewpoint, the average thickness of the TiCN layer is more preferably 3.3 µm or more and 13.0 µm or less, and even more preferably 4.0 µm or more and 12.5 µm or less.

In the lower layer used in the present embodiment, for example, from the viewpoint of further improving the wear resistance and fracture resistance, the average thickness of the TiCNO layer or the TiCO layer is preferably 0.05 µm or more and 1.4 µm or less. From the same viewpoint, the average thickness of the TiCNO layer or the TiCO layer is more preferably 0.1 µm or more and 1.0 µm or less, and even more preferably 0.2 µm or more and 0.5 µm or less.

The Ti compound layer of the lower layer is constituted of a Ti compound of Ti and at least one element selected from the group consisting of C, N, O and B, but may include a trace amount of component other than the above elements as long as the effects of the lower layer are exhibited.

### Intermediate Layer

The intermediate layer used in the present embodiment includes an α-Al₂O₃ layer containing α-aluminum oxide.

The average thickness of the intermediate layer used in the present embodiment is preferably 3.0 µm or more and 15.0 µm or less. In the coated cutting tool of the present embodiment, where the average thickness of the intermediate layer including the α-Al₂O₃ layer is 3.0 µm or more, the wear resistance tends to be excellent. Meanwhile, in the coated cutting tool of the present embodiment, where the average thickness of the intermediate layer including the α-Al₂O₃ layer is 15.0 µm or less, the adhesion of the coating layer is improved, so that the chipping resistance tends to be excellent. From the same viewpoint, the average thickness of the intermediate layer is more preferably 3.5 µm or more and 14.5 µm or less, and even more preferably 4.5 µm or more and 13.5 µm or less.

The intermediate layer only needs to include the α-Al₂O₃ layer containing α-aluminum oxide and may or may not contain components other than α-aluminum oxide (α-Al₂O₃) as long as the effects of the present invention are exhibited.

### Upper Layer

The upper layer used in the present embodiment includes a Ti compound layer containing a Ti compound of Ti and at least one element selected from the group consisting of C, N, O and B. The upper layer preferably includes a Ti compound layer containing a Ti compound of Ti, C, and at least one element selected from the group consisting of N, O and B. Examples of the Ti compound layer in the upper layer include a TiC layer containing TiC, a TiN layer containing TiN, a TiCN layer containing TiCN, a TiCO layer containing TiCO, a TiCNO layer containing TiCNO, a TiON layer containing TiON, and a TiB₂ layer containing TiB₂.

Among these, the upper layer preferably includes at least a TiCN layer and/or a TiCNO layer. Where the upper layer includes at least a TiCN layer and/or a TiCNO layer, the proportion of the length of the Σ11 grain boundary tends to be easily controlled to be the maximum among proportions of a length of each Σn grain boundary (n is an odd number of 3 or more and 29 or less) to the length of the CSL grain boundary of 100% in the upper layer. In addition, excellent balance between wear resistance and chipping resistance tends to be achieved.

In the coated cutting tool of the present embodiment, the proportion of the length of the Σ11 grain boundary to the length of the CSL grain boundary of 100% in the upper layer is 25% or more. In the coated cutting tool of the present embodiment, where the upper layer includes a Ti compound layer containing a Ti compound of Ti and at least one element selected from the group consisting of C, N, O and B and the proportion of the length of the Σ11 grain boundary to the length of the CSL grain boundary of 100% in the upper layer is 25% or more, the occurrence and propagation of cracks during cutting are suppressed, so that the chipping resistance is excellent, and the adhesion between the intermediate layer and the upper layer is also improved, so that high wear resistance and chipping resistance are exhibited over a long period. From the same viewpoint, the proportion of the length of the Σ11 grain boundary to the length of the CSL grain boundary of 100% in the upper layer is preferably 26% or more, more preferably 28% or more, and even more preferably 30% or more. Meanwhile, from the viewpoint of ease of production, the upper limit of the proportion of the length of the Σ11 grain boundary to the length of the CSL grain boundary of 100% in the upper layer is preferably 60% or less.

In the present application, the length of CSL grain boundaries means, among coincidence grain boundaries represented by a combination of Σ and a number, "the total length of Σ3 grain boundaries, Σ5 grain boundaries, Σ7 grain boundaries, Σ9 grain boundaries, Σ11 grain boundaries, Σ13 grain boundaries, Σ15 grain boundaries, Σ17 grain boundaries, Σ19 grain boundaries, Σ21 grain boundaries, Σ23 grain boundaries, Σ25 grain boundaries, Σ27 grain boundaries, and Σ29 grain boundaries".

The upper layer in the present embodiment has grain boundaries having relatively high grain boundary energy and grain boundaries having relatively low grain boundary energy. Usually, since the arrangement of atoms is irregular and disorder and atoms are randomly arranged, grain boundaries have many gaps and relatively high grain boundary energy. Meanwhile, some grain boundaries have regular arrangement of atoms and few gaps, and such grain boundaries have relatively low grain boundary energy. Representative examples of such grain boundaries having relatively low grain boundary energy include a coincidence site lattice grain boundary (hereinafter, also referred to as "the CSL grain boundary"). Grain boundaries give a significant effect on important sintering processes such as densification, creep, and diffusion, as well as on electrical, optical, and mechanical characteristics. The importance of grain boundaries depends on several factors such as a grain boundary density in a material, a chemical composition at an interface, and a crystallographic texture, specifically, a grain boundary plane orientation and a crystal grain misorientation. The CSL grain boundary plays a special role. A Σ value is known as an index indicating the degree of the distribution of the CSL grain boundary, and is defined as a ratio of a crystal lattice point density of two crystal grains that are in contact with each other at a grain boundary to a density of matching lattice points when both crystal lattices are superposed. In the case of a simple structure, it is generally recognized that a grain boundary having a low Σ value tends to have low interface energy and special characteristics. Thus, controlling the proportion of the CSL grain boundary and the distribution of the crystal grain misorientation is considered to be important for the characteristics of the upper layer and the improvement thereof.

In recent years, a technology based on a scanning electron microscope (hereinafter, also referred to as "SEM") known as electron backscatter diffraction (hereinafter, also referred to as "EBSD") is used to study grain boundaries in a material. EBSD is based on automatic analysis of Kikuchi diffraction patterns generated by backscattered electrons.

For each crystal grain of a target material, a crystallographic orientation is determined after preparing a corresponding diffraction pattern index. When EBSD is used together with commercially available software, texture analysis and determination of grain boundary character distribution (GBCD) are relatively easily carried out. When the interface is measured and analyzed by EBSD, the misorientation of the grain boundary in a sample group having a large interface can be clarified. Usually, the distribution of the misorientation is related to the treatment and/or physical properties of the material. The misorientation of the grain boundary is obtained from usual orientation parameters such as an Euler angle, an angle/axis pair, or a Rodrigues vector.

The CSL grain boundary of the upper layer usually includes Σ3 grain boundaries, Σ5 grain boundaries, Σ7 grain boundaries, Σ9 grain boundaries, Σ11 grain boundaries, Σ13 grain boundaries, Σ15 grain boundaries, Σ17 grain boundaries, Σ19 grain boundaries, Σ21 grain boundaries, Σ23 grain boundaries, Σ25 grain boundaries, Σ27 grain boundaries, and Σ29 grain boundaries. Here, for example, the length of the Σ11 grain boundary represents the total length of the Σ11 grain boundaries in a field of view (specific region) observed by an SEM equipped with EBSD.

Here, all grain boundaries are the sum of grain boundaries other than the CSL grain boundary and the CSL grain boundary. Hereinafter, grain boundaries other than the CSL grain boundary are referred to as "the general grain boundary" or "the random grain boundary". The general grain boundary refers to remaining grain boundaries excluding the CSL grain boundary from all grain boundaries of the crystal grains in the upper layer observed with an SEM equipped with EBSD. Therefore, "the total length of all grain boundaries" can be represented by "the sum of the length of the CSL grain boundary and the length of the general grain boundary".

In the coated cutting tool of the present embodiment, the proportion of the length of the Σ11 grain boundary is preferably the maximum among proportions of the length of each Σn grain boundary (n is an odd number of 3 or more and 29 or less) to the length of the CSL grain boundary of 100% in the upper layer. Where the proportion of the length of the Σ11 grain boundary is the maximum among proportions of the length of each Σn grain boundary (n is an odd number of 3 or more and 29 or less) to the length of the CSL grain boundary of 100% in the upper layer, the effect of increasing the proportion of the length of the Σ11 grain boundary to the length of the CSL grain boundary of 100% tends to be further effectively and reliably exhibited.

In the coated cutting tool of the present embodiment, the proportion of the length of the CSL grain boundary to the total length of all grain boundaries of 100% in the upper layer is preferably 20% or more and 60% or less. In the coated cutting tool of the present embodiment, where the proportion of the length of the CSL grain boundary to the total length of all grain boundaries of 100% in the upper layer is 20% or more, mechanical characteristics are improved and propagation of wear accompanied with falling off of grains is suppressed, so that the wear resistance tends to be further excellent. Meanwhile, in the coated cutting tool of the present embodiment, where the proportion of the length of the CSL grain boundary to the total length of all grain boundaries of 100% in the upper layer is 60% or less, coarsening of crystal grains can be suppressed, so that the surface roughness of the coating layer tends to be reduced, and cutting resistance is reduced, so that the wear resistance tends to be further excellent. From the same viewpoint, the proportion of the length of the CSL grain boundary to the total length of all grain boundaries of 100% in the upper layer is more preferably 21% or more and 59% or less, and even more preferably 23% or more and 55% or less.

In the present embodiment, the proportion of the length of the Σ11 grain boundary to the length of the CSL grain boundary of 100% in the upper layer and the proportion of the length of the CSL grain boundary to the total length of all grain boundaries of 100% can be calculated as follows.

A cross-section of the upper layer of the coated cutting tool is exposed in a direction perpendicular to the surface of the substrate to obtain an observation surface. Examples of the method for exposing the cross-section of the upper layer include cutting and polishing. Of these, polishing is preferable from the viewpoint of making the observation surface of the upper layer smoother. In particular, the observation surface is preferably a mirror surface from the viewpoint of being smoother. The method for obtaining a mirror observation surface of the upper layer is not particularly limited, and examples thereof include polishing using diamond paste or colloidal silica, and ion milling.

Thereafter, the above observation surface is observed with an SEM equipped with EBSD. As the observation region, a flat surface (such as a flank surface) is preferably observed.

As the SEM, SU6600 (manufactured by Hitachi High-Technologies Corporation) equipped with EBSD (manufactured by TexSEM Laboratories, Inc.) is used.

The normal to the observation surface is tilted by 70° with respect to an incident beam, and in the analysis, the observation surface is irradiated with an electron beam at an accelerating voltage of 15 kV and an irradiation current of 1.0 nA. Data collection is carried out by setting EBSD at a step size (distance between measurement points) of 0.1 µm in a measurement range including 50 µm in a direction parallel to the substrate surface and the entire upper layer in a direction perpendicular to the substrate surface on the observation surface and analyzing the crystal orientation of each grain in the upper layer in the measurement range. At this time, the boundary between measurement points having a misorientation of 5° or more is taken as the grain boundary.

Data processing is carried out by using commercially available software. The CSL grain boundaries corresponding to any arbitrary Σ value are counted and can be confirmed by being expressed as the ratio to all grain boundaries. As described above, the length of the CSL grain boundary in the upper layer, the length of the Σn grain boundary (n is an odd number of 3 or more and 29 or less), and the total length of all grain boundaries are described. The analysis is performed at three fields of view in total in the above-described measurement range on the observation surface, and the average value of respective numerical values is determined. The "Σn grain boundary where the proportion of the length is the maximum among proportions of the length of each Σn grain boundary (n is an odd number of 3 or more and 29 or less) to the length of the CSL grain boundary of 100%" in the upper layer can be specified from the obtained average values. In addition, the proportion of the length of the Σ11 grain boundary to the length of the CSL grain boundary of 100%, and the proportion of the length of the CSL grain boundary to the total length of all grain boundaries of 100% can be calculated.

The average thickness of the upper layer used in the present embodiment is 1.2 µm or more and 6.0 µm or less. In the coated cutting tool of the present embodiment, where the average thickness of the upper layer is 1.2 µm or more, the wear resistance is excellent. Meanwhile, where the average thickness of the upper layer is 6.0 µm or less, the adhesion of the coating layer is improved, so that the chipping resistance is excellent. From the same viewpoint, the average thickness of the upper layer is more preferably 1.4 µm or more and 5.9 µm or less, and even more preferably 1.6 µm or more and 5.5 µm or less.

The Ti compound layer in the upper layer is constituted of a Ti compound of Ti and at least one element selected from the group consisting of C, N, O and B, but may include a trace amount of component other than the above elements as long as the effects of the upper layer are exhibited.

### Outer Layer

The coating layer used in the present embodiment may include an outer layer on an interface of the upper layer opposite to the substrate (that is, on the surface of the upper layer). Examples of the outer layer include a compound layer containing at least one element selected from the group consisting of Ti, Zr, Hf, V, Nb, Ta, Cr, Mo, W, Al, Si and Y and at least one element selected from the group consisting of C, N, O and B (provided that the outer layer is a compound layer different from the upper layer). The outer layer being such a compound layer is preferable because the corner used tends to be easily identified. From the same viewpoint, the outer layer is more preferably a compound layer containing at least one element selected from the group consisting of Ti, Nb, Cr, Al, and Si, and at least one element selected from the group consisting of C, N, O and B (preferably includes a C element and/or an N element), even more preferably a compound layer containing at least one element selected from the group consisting of Ti, Cr, Al, and Si, and N, and particularly preferably a TiN layer containing TiN.

The average thickness of the outer layer is not particularly limited, and for example, may be 0.05 µm or more and 1.0 µm or less. From the viewpoint of further effectively and reliably exhibiting the effects by the present invention, the average thickness of the outer layer is preferably 0.1 µm or more and 0.5 µm or less, and more preferably 0.1 µm or more and 0.3 µm or less.

In the coated cutting tool of the present embodiment, each layer constituting the coating layer may be formed by a chemical vapor deposition method or a physical vapor deposition method. Specific examples of the method of forming each layer include the following methods. However, the method of forming each layer is not limiting.

### (Chemical vapor deposition method)

First, a lower layer composed of one or more Ti compound layers is formed on a surface of a substrate as follows.

For example, a Ti compound layer composed of a Ti nitride layer (hereinafter also referred to as "TiN layer") can be formed by a chemical vapor deposition method in which the raw material composition is TiCl₄: 5.0 mol% to 10.0 mol%, N₂: 20 mol% to 60 mol%, H₂: the balance, the temperature is 850°C to 950°C, and the pressure is 350 hPa to 450 hPa.

A Ti compound layer composed of a Ti carbide layer (hereinafter also referred to as "TiC layer") can be formed by a chemical vapor deposition method in which the raw material composition is TiCl₄: 1.5 mol% to 3.5 mol%, CH₄: 3.5 mol% to 5.5 mol%, H₂: the balance, the temperature is 950°C to 1,050°C, and the pressure is 70 hPa to 80 hPa.

A Ti compound layer composed of a Ti carbonitride layer (hereinafter also referred to as "TiCN layer") can be formed by a chemical vapor deposition method in which the raw material composition is TiCl₄: 5.0 mol% to 7.0 mol%, CH₃CN: 0.5 mol% to 1.5 mol%, H₂: the balance, the temperature is 800°C to 900°C, and the pressure is 70 hPa to 90 hPa.

A Ti compound layer composed of a Ti oxycarbonitride layer (hereinafter also referred to as "TiCNO layer") can be formed by a chemical vapor deposition method in which the raw material composition is TiCl₄: 3.0 mol% to 4.0 mol%, CO: 0.5 mol% to 1.0 mol%, N₂: 30 mol% to 40 mol%, H₂: the balance, the temperature is 950°C to 1,050°C, and the pressure is 50 hPa to 150 hPa.

A Ti compound layer composed of a Ti carboxide layer (hereinafter also referred to as "TiCO layer") can be formed by a chemical vapor deposition method in which the raw material composition is TiCl₄: 1.0 mol% to 2.0 mol%, CO: 2.0 mol% to 3.0 mol%, H₂: the balance, the temperature is 950°C to 1,050°C, and the pressure is 50 hPa to 150 hPa.

An intermediate layer composed of an α-Al₂O₃ layer containing α-aluminum oxide (hereinafter simply referred to as "Al₂O₃ layer") can be formed by, for example, the method set forth below.

First, among the layers of the lower layer, a surface of the layer farthest from the substrate is oxidized. Thereafter, an intermediate layer including an α-Al₂O₃ layer is formed on the surface of the layer farthest from the substrate.

More specifically, the oxidation of the surface of the layer farthest from the substrate is performed under the conditions of the gas composition of CO₂: 0.3 to 1.0 mol%, H₂: the balance, the temperature of 950 to 1,050°C, and the pressure of 60 to 80 hPa (oxidation step). The oxidation treatment time in this case is preferably 1 min to 10 min.

Then, the α-Al₂O₃ layer is formed by a chemical vapor deposition method in which the raw material gas composition is AlCl₃: 2.0 to 5.0 mol%, CO₂: 2.5 to 4.0 mol%, HCl: 2.0 to 3.0 mol%, H₂S: 0.10 to 0.30 mol%, H₂: the balance, the temperature is 950 to 1,050°C, and the pressure is 60 to 80 hPa (film formation step).

Further, an upper layer composed of a Ti compound layer (e.g., a TiCN layer and/or a TiCNO layer) is formed on the surface of the α-Al₂O₃ layer (upper layer formation step).

A Ti compound layer composed of a Ti carbonitride layer (hereinafter also referred to as "TiCN layer") can be formed by a chemical vapor deposition method in which the raw material composition is TiCl₄: 4.8 to 7.5 mol%, CH₃CN: 0.4 to 1.0 mol%, C₂H₄: 0.6 to 1.0 mol%, N₂: 5.0 to 12.5 mol%, H₂: the balance, the temperature is 970 to 1,020°C, and the pressure is 80 to 120 hPa.

A Ti compound layer composed of a Ti oxycarbonitride layer (hereinafter also referred to as "TiCNO layer" can be formed by a chemical vapor deposition method in which the raw material composition is TiCl₄: 4.8 to 7.5 mol%, CO: 1.6 to 2.2 mol%, C₂H₄: 0.6 to 1.0 mol%, N₂: 5.0 to 12.5 mol%, H₂: the balance, the temperature is 970 to 1,020°C, and the pressure is 80 to 120 hPa.

To set the proportion of the length of the Σ11 grain boundary to the length of the CSL grain boundary of 100% in the upper layer to a specific value or more, for example, the pressure is only required to be controlled and the proportion of C₂H₄ in the raw material composition is only required to be controlled in the step of forming the upper layer (e.g., a TiCN layer and/or a TiCNO layer). More specifically, when the pressure is reduced in the step of forming the upper layer, the proportion of the length of the Σ11 grain boundary to the length of the CSL grain boundary of 100% in the upper layer can be increased. In addition, when the proportion of C₂H₄ in the raw material composition is increased, the proportion of the length of the Σ11 grain boundary to the length of the CSL grain boundary of 100% in the upper layer can be increased.

When C₂H₄ is used as the raw material composition in the step of forming the upper layer (e.g., a TiCN layer and/or a TiCNO layer), the proportion of the length of the Σ11 grain boundary tends to be the maximum among proportions of the length of each Σn grain boundary (n is an odd number of 3 or more and 29 or less) to the length of the CSL grain boundary of 100% in the upper layer, and the proportion of the length of the Σ11 grain boundary to the length of the CSL grain boundary of 100% in the upper layer tends to be increased.

To set the proportion of the length of the CSL grain boundary to the total length of all grain boundaries of 100% in the upper layer to a specific range, for example, the pressure is only required to be controlled and the proportion of H₂ in the raw material composition is only required to be controlled in the step of forming the upper layer (e.g., a TiCN layer and/or a TiCNO layer). More specifically, when the pressure is reduced in the step of forming the upper layer, the proportion of the length of the CSL grain boundary to the total length of all grain boundaries of 100% in the upper layer can be increased. In addition, when the proportion of H₂ in the raw material composition is increased, the proportion of the length of the CSL grain boundary to the total length of all grain boundaries of 100% in the upper layer can be increased.

As necessary, an outer layer can be formed on the surface of the upper layer as follows.

For example, a layer composed of a Ti nitride layer (hereinafter also referred to as a "TiN layer") serving as the outer layer can be formed by a chemical vapor deposition method in which the raw material composition is TiCl₄: 2.0 to 6.0 mol%, N₂: 10.0 to 30.0 mol%, H₂: the balance, the temperature is 950 to 1,050°C, and the pressure is 400 to 500 hPa.

The thickness of each layer in the coating layers of the coated cutting tool of the present embodiment can be measured by observing the sectional structure of the coated cutting tool using an optical microscope, a scanning electron microscope (SEM), a field emission scanning electron microscope (FE-SEM), or the like. In addition, the average thickness of each layer in the coated cutting tool of the present embodiment can be obtained by measuring the thickness of each layer at three or more locations in the vicinity of a position of 50 µm from the edge ridge portion toward the center of the flank surface of the coated cutting tool and finding the arithmetic mean value thereof. Further, the composition of each layer in the coating layer of the coated cutting tool of the present embodiment can be measured from the sectional structure of the coated cutting tool by using an energy dispersive X-ray spectrometer (EDS), a wavelength dispersive X-ray spectrometer (WDS), or the like.

### Examples

Hereinafter, the present invention will be described in more detail with reference to examples, but the present invention is not limited to these examples.

As a substrate, cemented carbide machined to have an insert shape of CNMG120412 (ISO standard) and having a composition of 87.0%WC-8.6%Co-2.0%TiN-2.0%NbC-0.4%Cr₃C₂ (above mass%) was prepared. After round honing was performed on the edge ridge portion of the substrate with a SiC brush, the surface of the substrate was washed.

### [Invention Samples 1 to 25 and Comparative Samples 1 to 10]

After washing the surface of the substrate, a coating layer was formed by a chemical vapor deposition method. First, the substrate was placed into an external heating type chemical vapor deposition apparatus, and under the conditions of the raw material gas composition, temperature and pressure shown in Table 1, the lower layer having the composition shown in Table 2 was formed on the surface of the substrate in the order of the first layer, the second layer, and the third layer to obtain the average thickness shown in Table 2. Next, the surface of the lower layer was subjected to oxidation treatment under the conditions of a gas composition of CO₂: 0.5 mol%, H₂: 99.5 mol%, a temperature of 1,000°C, and a pressure of 70 hPa for 5 minutes. Then, an intermediate layer containing α-aluminum oxide was formed on the surface of the lower layer subjected to the oxidation treatment under the conditions of the raw material gas composition, temperature, and pressure shown in Table 1 to obtain the average thickness shown in Table 2. Then, the upper layer having the composition shown in Table 2 was formed on the surface of the intermediate layer under the conditions of the raw material gas composition, temperature, and pressure shown in Table 3 to obtain the average thickness shown in Table 2. For Invention Samples 22 to 25, an outer layer containing TiN was further formed on the surface of the upper layer under the conditions of the raw material gas composition, temperature, and pressure shown in Table 1 to obtain the average thickness shown in Table 2. Thus, the coated cutting tools of Invention Samples 1 to 25 and Comparative Samples 1 to 10 were obtained.

**[Table 1]**

| | Composition of each layer | Temperature (°C) | Pressure (hPa) | Raw material gas composition (mol%) |
|---|---|---|---|---|
| Lower layer | TiN | 900 | 400 | TiCl₄:7.5%, N₂:40%, H₂:52.5% |
| | TiC | 1000 | 75 | TiCl₄:2.4%, CH₄:4.6%, H₂:93.0% |
| | TiCN | 850 | 80 | TiCl₄:6.0%, CH₃CN:1.15%, H₂:92.85% |
| | TiCNO | 1000 | 100 | TiCl₄:3.5%, CO:0.7%, N₂:35.5%, H₂:60.3% |
| | TiCO | 1000 | 80 | TiCl₄:1.3%, CO:2.7%, H₂:96.0% |
| Intermediate layer | α-Al₂O₃ | 1000 | 70 | AlCl₃:2.5%, CO₂:3.0%, HCl:2.5%, H₂S:0.2%, H₂:91.8% |
| Outer layer | TiN | 1000 | 450 | TiCl₄:4.0%, N₂:15.0%, H₂:81.0% |

**[Table 2]**

| Sample Number | Coating layer | | | | | | | | | | | | | | |
|---|---|---|---|---|---|---|---|---|---|---|---|---|---|---|---|
| | Lower layer | | | | | | | Intermediate layer | | | Upper layer | | Outer layer | | Average thickness of entire coating layer (µm) |
| | First layer | | Second layer | | Third layer | | Average thickness of entire layer (µm) | Composition | Crystal system | Average thickness (µm) | Composition | Average thickness (µm) | Composition | Average thickness (µm) | |
| | Composition | Average thickness (µm) | Composition | Average thickness (µm) | Composition | Average thickness (µm) | | | | | | | | | |
| Invention Sample 1 | TiN | 0.3 | TiCN | 6.5 | TiCNO | 0.2 | 7.0 | Al₂O₃ | α | 7.0 | TiCN | 3.0 | - | - | 17.0 |
| Invention Sample 2 | TiN | 0.3 | TiCN | 6.5 | TiCNO | 0.2 | 7.0 | Al₂O₃ | α | 7.0 | TiCN | 3.0 | - | - | 17.0 |
| Invention Sample 3 | TiN | 0.3 | TiCN | 6.5 | TiCNO | 0.2 | 7.0 | Al₂O₃ | α | 7.0 | TiCN | 3.0 | - | - | 17.0 |
| Invention Sample 4 | TiN | 0.3 | TiCN | 6.5 | TiCNO | 0.2 | 7.0 | Al₂O₃ | α | 7.0 | TiCN | 3.0 | - | - | 17.0 |
| Invention Sample 5 | TiN | 0.3 | TiCN | 6.5 | TiCNO | 0.2 | 7.0 | Al₂O₃ | α | 7.0 | TiCN | 3.0 | - | - | 17.0 |
| Invention Sample 6 | TiN | 0.3 | TiCN | 6.5 | TiCNO | 0.2 | 7.0 | Al₂O₃ | α | 7.0 | TiCN | 3.0 | - | - | 17.0 |
| Invention Sample 7 | TiN | 0.3 | TiCN | 6.5 | TiCNO | 0.2 | 7.0 | Al₂O₃ | α | 7.0 | TiCN | 3.0 | - | - | 17.0 |
| Invention Sample 8 | TiN | 0.3 | TiCN | 2.5 | TiCNO | 0.2 | 3.0 | Al₂O₃ | α | 7.0 | TiCN | 2.0 | - | - | 120 |
| Invention Sample 9 | TiN | 0.1 | TiCN | 13.0 | TiCNO | 1.4 | 14.5 | Al₂O₃ | α | 4.5 | TiCN | 3.0 | - | - | 22.0 |
| Invention Sample 10 | TiN | 0.3 | TiCN | 12.5 | TiCNO | 0.2 | 13.0 | Al₂O₃ | α | 3.0 | TiCN | 1.6 | - | - | 17.6 |
| Invention Sample 11 | TiN | 0.3 | TiCN | 4.0 | TiCNO | 0.2 | 4.5 | Al₂O₃ | α | 14.5 | TiCN | 3.0 | - | - | 22.0 |
| Invention Sample 12 | TiN | 0.3 | TiCN | 7.5 | TiCNO | 0.2 | 8.0 | Al₂O₃ | α | 8.0 | TiCN | 1.2 | - | - | 17.2 |
| Invention Sample 13 | TiN | 1.0 | TiCN | 3.3 | TiCNO | 0.2 | 4.5 | Al₂O₃ | α | 8.0 | TiCN | 5.9 | - | - | 18.4 |
| Invention Sample 14 | TiN | 0.3 | TiCN | 5.0 | TiCNO | 0.3 | 5.6 | Al₂O₃ | α | 3.5 | TiCN | 1.4 | - | - | 10.5 |
| Invention Sample 15 | TiN | 0.3 | TiCN | 5.0 | TiCNO | 0.2 | 5.5 | Al₂O₃ | α | 13.5 | TiCN | 5.5 | - | - | 24.5 |
| Invention Sample 16 | TiC | 0.3 | TiCN | 6.5 | TiCNO | 0.2 | 7.0 | Al₂O₃ | α | 8.0 | TiCN | 3.0 | - | - | 18.0 |
| Invention Sample 17 | TiN | 0.3 | TiCN | 6.5 | TiCO | 0.2 | 7.0 | Al₂O₃ | α | 8.0 | TiCN | 3.0 | - | - | 18.0 |
| Invention Sample 18 | TiN | 0.3 | TiCN | 7.5 | TiCNO | 0.2 | 8.0 | Al₂O₃ | α | 8.0 | TiCNO | 1.4 | - | - | 17.4 |
| Invention Sample 19 | TiN | 0.3 | TiCN | 7.5 | TiCNO | 0.2 | 8.0 | Al₂O₃ | α | 8.0 | TiCNO | 3.0 | - | - | 19.0 |
| Invention Sample 20 | TiN | 0.3 | TiCN | 7.5 | TiCNO | 0.2 | 8.0 | Al₂O₃ | α | 8.0 | TiCNO | 3.0 | - | - | 19.0 |
| Invention Sample 21 | TiN | 0.3 | TiCN | 5.5 | TiCNO | 0.2 | 6.0 | Al₂O₃ | α | 6.0 | TiCNO | 5.2 | - | - | 17.2 |
| Invention Sample 22 | TiN | 0.3 | TiCN | 6.5 | TiCNO | 0.2 | 7.0 | Al₂O₃ | α | 7.0 | TiCN | 3.0 | TiN | 0.5 | 17.5 |
| Invention Sample 23 | TiN | 0.3 | TiCN | 3.5 | TiCNO | 0.2 | 4.0 | Al₂O₃ | α | 6.0 | TiCN | 2.0 | TiN | 0.1 | 12.1 |
| Invention Sample 24 | TiN | 0.3 | TiCN | 5.5 | TiCNO | 0.2 | 6.0 | Al₂O₃ | α | 11.0 | TiCN | 5.0 | TiN | 1.0 | 23.0 |
| Invention Sample 25 | TiN | 0.3 | TiCN | 7.5 | TiCNO | 0.2 | 8.0 | Al₂O₃ | α | 8.0 | TiCNO | 3.0 | TiN | 0.3 | 19.3 |
| Comparative Sample 1 | TiN | 0.3 | TiCN | 6.5 | TiCNO | 0.2 | 7.0 | Al₂O₃ | α | 7.0 | TiCN | 3.0 | - | - | 17.0 |
| Comparative Sample 2 | TiN | 0.3 | TiCN | 6.5 | TiCNO | 0.2 | 7.0 | Al₂O₃ | α | 7.0 | TiCN | 3.0 | - | - | 17.0 |
| Comparative Sample 3 | TiN | 0.3 | TiCN | 6.5 | TiCNO | 0.2 | 7.0 | Al₂O₃ | α | 7.0 | TiCNO | 3.0 | - | - | 17.0 |
| Comparative Sample 4 | TiN | 0.3 | TiCN | 6.5 | TiCNO | 0.2 | 7.0 | Al₂O₃ | α | 7.0 | TiN | 3.0 | - | - | 17.0 |
| Comparative Sample 5 | TiN | 0.3 | TiCN | 6.5 | TiCNO | 0.2 | 7.0 | Al₂O₃ | α | 7.0 | TiCN | 3.0 | - | - | 17.0 |
| Comparative Sample 6 | TiN | 0.3 | TiCN | 2.5 | TiCNO | 0.2 | 3.0 | Al₂O₃ | α | 3.0 | TiCN | 2.0 | - | - | 8.0 |
| Comparative Sample 7 | TiN | 0.3 | TiCN | 4.5 | TiCNO | 0.2 | 5.0 | Al₂O₃ | α | 4.0 | TiCN | 8.0 | - | - | 17.0 |
| Comparative Sample 8 | TiN | 0.3 | TiCN | 11.5 | TiCNO | 0.2 | 12.0 | Al₂O₃ | α | 12.0 | TiCN | 3.0 | - | - | 27.0 |
| Comparative Sample 9 | TiN | 0.3 | TiCN | 7.0 | TiCNO | 0.2 | 7.5 | Al₂O₃ | α | 12.0 | TiCN | 8.0 | - | - | 27.5 |
| Comparative Sample 10 | TiN | 0.3 | TiCN | 16.0 | TiCNO | 0.2 | 16.5 | Al₂O₃ | α | 7.5 | TiCN | 3.0 | - | - | 27.0 |

| | | | | | | | | | | | | | | | |
|---|---|---|---|---|---|---|---|---|---|---|---|---|---|---|---|
| * "-" indicates that the layer was not formed. | | | | | | | | | | | | | | | |

**[Table 3]**

| Sample Number | Composition of upper layer | Temperature (°C) | Pressure (hPa) | Raw material gas composition (mol%) | | | | | | |
|---|---|---|---|---|---|---|---|---|---|---|
| | | | | TiCl₄ | CH₃CN | CO | CH₄ | C₂H₄ | N₂ | H₂ |
| Invention Sample 1 | TiCN | 1000 | 100 | 6.5 | 0.7 | 0.0 | 0.0 | 0.8 | 10.0 | 82.0 |
| Invention Sample 2 | TiCN | 1020 | 120 | 7.5 | 0.4 | 0.0 | 0.0 | 0.6 | 12.5 | 79.0 |
| Invention Sample 3 | TiCN | 1000 | 100 | 6.0 | 0.4 | 0.0 | 0.0 | 0.6 | 11.0 | 82.0 |
| Invention Sample 4 | TiCN | 980 | 80 | 5.0 | 0.5 | 0.0 | 0.0 | 1.0 | 6.5 | 87.0 |
| Invention Sample 5 | TiCN | 980 | 120 | 7.0 | 0.7 | 0.0 | 0.0 | 0.8 | 11.5 | 80.0 |
| Invention Sample 6 | TiCN | 1000 | 80 | 5.7 | 0.5 | 0.0 | 0.0 | 0.8 | 5.0 | 88.0 |
| Invention Sample 7 | TiCN | 1000 | 120 | 6.0 | 0.4 | 0.0 | 0.0 | 0.6 | 11.0 | 82.0 |
| Invention Sample 8 | TiCN | 1020 | 100 | 6.5 | 0.7 | 0.0 | 0.0 | 0.8 | 10.0 | 82.0 |
| Invention Sample 9 | TiCN | 1000 | 100 | 5.7 | 1.0 | 0.0 | 0.0 | 0.8 | 10.5 | 82.0 |
| Invention Sample 10 | TiCN | 1000 | 100 | 6.0 | 0.7 | 0.0 | 0.0 | 0.8 | 10.5 | 82.0 |
| Invention Sample 11 | TiCN | 990 | 100 | 6.7 | 0.5 | 0.0 | 0.0 | 0.8 | 10.0 | 82.0 |
| Invention Sample 12 | TiCN | 1000 | 100 | 6.5 | 0.7 | 0.0 | 0.0 | 0.8 | 10.0 | 82.0 |
| Invention Sample 13 | TiCN | 1000 | 100 | 5.7 | 1.0 | 0.0 | 0.0 | 0.8 | 10.0 | 82.5 |
| Invention Sample 14 | TiCN | 1010 | 100 | 5.5 | 0.7 | 0.0 | 0.0 | 0.8 | 10.0 | 83.0 |
| Invention Sample 15 | TiCN | 970 | 100 | 5.8 | 0.4 | 0.0 | 0.0 | 0.8 | 11.0 | 82.0 |
| Invention Sample 16 | TiCN | 1000 | 100 | 7.5 | 0.7 | 0.0 | 0.0 | 0.8 | 9.0 | 82.0 |
| Invention Sample 17 | TiCN | 980 | 100 | 6.5 | 0.7 | 0.0 | 0.0 | 0.8 | 10.0 | 82.0 |
| Invention Sample 18 | TiCNO | 1000 | 100 | 5.2 | 0.0 | 1.8 | 0.0 | 0.8 | 10.0 | 82.2 |
| Invention Sample 19 | TiCNO | 1020 | 80 | 4.8 | 0.0 | 2.2 | 0.0 | 0.8 | 10.0 | 82.2 |
| Invention Sample 20 | TiCNO | 1020 | 100 | 5.6 | 0.0 | 1.6 | 0.0 | 0.6 | 10.0 | 82.2 |
| Invention Sample 21 | TiCNO | 1000 | 120 | 5.4 | 0.0 | 1.8 | 0.0 | 0.6 | 5.0 | 87.2 |
| Invention Sample 22 | TiCN | 1000 | 100 | 6.0 | 0.7 | 0.0 | 0.0 | 0.8 | 10.0 | 82.5 |
| Invention Sample 23 | TiCN | 1000 | 120 | 6.5 | 0.7 | 0.0 | 0.0 | 0.8 | 10.0 | 82.0 |
| Invention Sample 24 | TiCN | 980 | 100 | 6.7 | 0.5 | 0.0 | 0.0 | 0.8 | 10.0 | 82.0 |
| Invention Sample 25 | TiCNO | 980 | 120 | 5.2 | 0.0 | 2.0 | 0.0 | 0.6 | 10.0 | 82.2 |
| Comparative Sample 1 | TiCN | 980 | 150 | 6.5 | 0.5 | 0.0 | 1.0 | 0.0 | 15.0 | 77.0 |
| Comparative Sample 2 | TiCN | 1000 | 150 | 6.5 | 0.5 | 0.0 | 0.8 | 0.2 | 15.0 | 77.0 |
| Comparative Sample 3 | TiCNO | 1010 | 150 | 4.0 | 0.0 | 2.5 | 1.5 | 0.0 | 10.0 | 82.0 |
| Comparative Sample 4 | TiN | 950 | 150 | 5.0 | 0.0 | 0.0 | 0.0 | 0.0 | 40.0 | 55.0 |
| Comparative Sample 5 | TiCN | 1000 | 120 | 6.0 | 1.0 | 0.0 | 0.8 | 0.2 | 10.0 | 82.0 |
| Comparative Sample 6 | TiCN | 980 | 100 | 6.5 | 0.7 | 0.0 | 0.0 | 0.8 | 10.0 | 82.0 |
| Comparative Sample 7 | TiCN | 1020 | 100 | 6.0 | 0.5 | 0.0 | 0.0 | 0.8 | 10.0 | 82.7 |
| Comparative Sample 8 | TiCN | 980 | 100 | 5.5 | 0.7 | 0.0 | 0.0 | 0.8 | 11.0 | 82.0 |
| Comparative Sample 9 | TiCN | 980 | 100 | 6.5 | 0.7 | 0.0 | 0.0 | 0.8 | 10.0 | 82.0 |
| Comparative Sample 10 | TiCN | 1000 | 100 | 6.2 | 1.0 | 0.0 | 0.0 | 0.8 | 10.0 | 82.0 |

### [Average thickness of each layer]

The average thickness of each layer of the obtained sample was determined in the following manner. That is, using FE-SEM, the thickness at three points in the cross section in the vicinity of the position of 50 µm from the edge ridge portion of the coated cutting tool toward the center of the flank surface was measured, and the arithmetic mean value was determined as the average thickness. The measurement results are shown in Table 2.

### [Composition of each layer]

The composition of each layer of the obtained sample was measured using EDS in the cross section near the position of 50 µm from the edge ridge portion of the coated cutting tool toward the center of the flank surface. The measurement results are shown in Table 2.

### [Length of grain boundary]

The proportion of the length of the Σ11 grain boundary to the length of the CSL grain boundary of 100% in the upper layer and the proportion of the length of the CSL grain boundary to the total length of all grain boundaries of 100% of the obtained samples were measured as follows.

The coated cutting tool was polished in a direction perpendicular to the surface of the substrate until the cross-section of the upper layer is exposed to obtain an observation surface. The obtained observation surface was polished using colloidal silica to obtain a mirror observation surface.

Thereafter, the above observation surface was observed with an SEM equipped with EBSD. As the observation region, a flank surface was observed.

As the SEM, SU6600 (manufactured by Hitachi High-Technologies Corporation) equipped with EBSD (manufactured by TexSEM Laboratories, Inc.) was used.

The normal to the observation surface was tilted by 70° with respect to an incident beam, and in the analysis, the observation surface was irradiated with an electron beam at an accelerating voltage of 15 kV and an irradiation current of 1.0 nA. Data collection was carried out by setting EBSD at a step size (distance between measurement points) of 0.1 µm in a measurement range including 50 µm in a direction parallel to the substrate surface and the entire upper layer in a direction perpendicular to the substrate surface on the observation surface and analyzing the crystal orientation of each grain in the upper layer in the measurement range. At this time, the boundary between measurement points having a misorientation of 5° or more was taken as the grain boundary.

Data processing was carried out by using commercially available software. The CSL grain boundaries corresponding to any arbitrary Σn value were counted and confirmed by being expressed as the ratio to all grain boundaries. As described above, the length of CSL grain boundaries, the length of the Σn grain boundary (n is an odd number of 3 or more and 29 or less) and the total length of all grain boundaries in the upper layer were determined. The analysis was performed at three fields of view in total in the above-described measurement range on the observation surface, and the average value of respective numerical values was determined. The "Σn grain boundary where the proportion of the length is the maximum among proportions of the length of each Σn grain boundary (n is an odd number of 3 or more and 29 or less) to the length of the CSL grain boundary of 100% (hereinafter, also referred to as "Σn where Σn/CSL is the maximum")" in the upper layer was specified from the obtained average values. In addition, the proportion of the length of the Σ11 grain boundary to the length of the CSL grain boundary of 100% in the upper layer (hereinafter, also referred to as "Σ11/CSL") and the proportion of the length of the CSL grain boundary to the total length of all grain boundaries of 100% (hereinafter, also referred to as "CSL/all grain boundaries") were calculated. The results are shown in Table 4.

**[Table 4]**

| Sample Number | Upper layer | | |
|---|---|---|---|
| | Σ11/CSL (%) | Σn where Σn/CSL is the maximum | CSL/All grain boundaries (%) |
| Invention Sample 1 | 39 | Σ11 | 41 |
| Invention Sample 2 | 26 | Σ11 | 23 |
| Invention Sample 3 | 30 | Σ11 | 38 |
| Invention Sample 4 | 58 | Σ11 | 55 |
| Invention Sample 5 | 33 | Σ11 | 21 |
| Invention Sample 6 | 51 | Σ11 | 59 |
| Invention Sample 7 | 28 | Σ11 | 35 |
| Invention Sample 8 | 41 | Σ11 | 42 |
| Invention Sample 9 | 40 | Σ11 | 41 |
| Invention Sample 10 | 41 | Σ11 | 39 |
| Invention Sample 11 | 41 | Σ11 | 40 |
| Invention Sample 12 | 40 | Σ11 | 38 |
| Invention Sample 13 | 40 | Σ11 | 40 |
| Invention Sample 14 | 41 | Σ11 | 39 |
| Invention Sample 15 | 39 | Σ11 | 41 |
| Invention Sample 16 | 39 | Σ11 | 41 |
| Invention Sample 17 | 39 | Σ11 | 40 |
| Invention Sample 18 | 42 | Σ11 | 39 |
| Invention Sample 19 | 53 | Σ11 | 44 |
| Invention Sample 20 | 33 | Σ11 | 38 |
| Invention Sample 21 | 30 | Σ11 | 47 |
| Invention Sample 22 | 37 | Σ11 | 42 |
| Invention Sample 23 | 33 | Σ11 | 35 |
| Invention Sample 24 | 42 | Σ11 | 41 |
| Invention Sample 25 | 29 | Σ11 | 34 |
| Comparative Sample 1 | 5 | Σ3 | 16 |
| Comparative Sample 2 | 9 | Σ11 | 15 |
| Comparative Sample 3 | 9 | Σ5 | 28 |
| Comparative Sample 4 | 4 | Σ3 | 10 |
| Comparative Sample 5 | 21 | Σ11 | 25 |
| Comparative Sample 6 | 38 | Σ11 | 38 |
| Comparative Sample 7 | 37 | Σ11 | 42 |
| Comparative Sample 8 | 39 | Σ11 | 41 |
| Comparative Sample 9 | 38 | Σ11 | 41 |
| Comparative Sample 10 | 41 | Σ11 | 38 |

Using the obtained Invention Samples 1 to 25 and Comparative Samples 1 to 10, cutting test 1 and cutting test 2 were conducted under the following conditions. Cutting test 1 is a chipping test for evaluating chipping resistance, and cutting test 2 is a wear test for evaluating wear resistance. The results of the respective cutting tests are shown in Table 5.

### [Cutting Test 1]

Work material: round bar of SCM415 with two grooves at an equal distance on the outer peripheral surface,
Cutting speed: 200 m/min,
Feed: 0.30 mm/rev,
Depth of cut: 1.5 mm,
Coolant: Water-soluble coolant was used,
Evaluation item: A time when a sample was fractured was defined as the end of the tool life, and the number of shocks to reach the end of the tool life was measured. By observing the cutting edge of the tool with a stereoscopic microscope (100-fold magnification) every 500 shocks, the occurrence of chipping as a starting point of fracture was confirmed before the sample was fractured.

### [Cutting Test 2]

Work material: round bar of S45,
Cutting speed: 200 m/min,
Feed: 0.40 mm/rev,
Depth of cut: 2.0 mm,
Coolant: water-soluble coolant was used,
Evaluation item: A time when a sample was fractured or had a maximum flank wear width of 0.3 mm was defined as the end of the tool life, and the machining time to reach the end of the tool life was measured.

Regarding the number of shocks to reach the end of the tool life in cutting test 1 (chipping test), 15000 shocks or more were evaluated as "A", 10000 shocks or more and less than 15000 shocks were evaluated as "B", and less than 10000 shocks were evaluated as "C". Regarding the machining time to reach the end of the tool life in cutting test 2 (wear test), 40 min or more was evaluated as "A", 30 min or more and less than 40 min was evaluated as "B", and less than 30 min was evaluated as "C". In this evaluation, "A" is the best, "B" is the second best, and "C" is the worst, and having many "A" or "B" means excellent cutting performance. Table 5 shows the obtained evaluation results.

**[Table 5]**

| Sample Number | Cutting test 1 | | Cutting test 2 | |
|---|---|---|---|---|
| | Tool life (number of shocks) | Evaluati on | Tool life (minutes) | Evaluati on |
| Invention Sample 1 | 15000 | A | 37 | B |
| Invention Sample 2 | 11000 | B | 31 | B |
| Invention Sample 3 | 13000 | B | 36 | B |
| Invention Sample 4 | 21000 | A | 44 | A |
| Invention Sample 5 | 12500 | B | 32 | B |
| Invention Sample 6 | 19500 | A | 45 | A |
| Invention Sample 7 | 11500 | B | 35 | B |
| Invention Sample 8 | 16500 | A | 32 | B |
| Invention Sample 9 | 14000 | B | 43 | A |
| Invention Sample 10 | 16000 | A | 35 | B |
| Invention Sample 11 | 14000 | B | 41 | A |
| Invention Sample 12 | 16500 | A | 34 | B |
| Invention Sample 13 | 12500 | B | 37 | B |
| Invention Sample 14 | 18500 | A | 30 | B |
| Invention Sample 15 | 12000 | B | 42 | A |
| Invention Sample 16 | 14000 | B | 35 | B |
| Invention Sample 17 | 14500 | B | 36 | B |
| Invention Sample 18 | 16500 | A | 32 | B |
| Invention Sample 19 | 20000 | A | 38 | B |
| Invention Sample 20 | 15500 | A | 34 | B |
| Invention Sample 21 | 14000 | B | 38 | B |
| Invention Sample 22 | 14500 | B | 38 | B |
| Invention Sample 23 | 14000 | B | 31 | B |
| Invention Sample 24 | 13000 | B | 44 | A |
| Invention Sample 25 | 14500 | B | 32 | B |
| Comparative Sample 1 | 3500 | C | 23 | C |
| Comparative Sample 2 | 7000 | C | 25 | C |
| Comparative Sample 3 | 4500 | C | 27 | C |
| Comparative Sample 4 | 2500 | C | 19 | C |
| Comparative Sample 5 | 9000 | C | 30 | B |
| Comparative Sample 6 | 18000 | A | 25 | C |
| Comparative Sample 7 | 9000 | C | 31 | B |
| Comparative Sample 8 | 8500 | C | 29 | C |
| Comparative Sample 9 | 4500 | C | 24 | C |
| Comparative Sample 10 | 7500 | C | 26 | C |

From the results shown in Table 5, the evaluations of the chipping test and the wear test of the Invention Samples were both "A" or "B". Meanwhile, the evaluation of the Comparative Samples was "C" in either or both of the chipping test and the wear test. Therefore, it can be seen that the chipping resistance and the wear resistance of Invention Samples are generally superior to those of the Comparative Samples.

From the above results, it was found that the Invention Samples have a long tool life as a result of being excellent in chipping resistance and wear resistance.

### Industrial Applicability

Since the coated cutting tool of the present invention has excellent chipping resistance and wear resistance, the tool life can be extended as compared with the conventional coated cutting tool, and from such a viewpoint, the coated cutting tool of the present invention has industrial applicability.

### Reference Signs List

1: Substrate, 2: Lower layer, 3: Intermediate layer, 4: Upper layer, 5: Coating layer, 6: Coated cutting tool.

## Claims

1. A coated cutting tool comprising a substrate and a coating layer formed on a surface of the substrate, wherein
the coating layer comprises a lower layer, an intermediate layer, and an upper layer layered in this order from the substrate side to the surface side of the coating layer,
the lower layer comprises a Ti compound layer containing a Ti compound of Ti and at least one element selected from the group consisting of C, N, O and B,
the intermediate layer comprises an α-Al₂O₃ layer containing α-aluminum oxide,
the upper layer comprises a Ti compound layer containing a Ti compound of Ti and at least one element selected from the group consisting of C, N, O and B,
an average thickness of the entire coating layer is 10.0 µm or more and 25.0 µm or less,
an average thickness of the upper layer is 1.2 µm or more and 6.0 µm or less, and
a proportion of a length of a Σ11 grain boundary to a length of a CSL grain boundary of 100% in the upper layer is 25% or more.

2. The coated cutting tool according to claim 1, wherein the proportion of the length of the Σ11 grain boundary is the maximum among proportions of a length of each Σn grain boundary (n is an odd number of 3 or more and 29 or less) to the length of the CSL grain boundary of 100% in the upper layer.

3. The coated cutting tool according to claim 1 or 2, wherein the proportion of the length of the CSL grain boundary to a total length of all grain boundaries of 100% in the upper layer is 20% or more and 60% or less.

4. The coated cutting tool according to any one of claims 1 to 3, wherein the upper layer comprises at least a TiCN layer and/or a TiCNO layer.

5. The coated cutting tool according to any one of claims 1 to 4, wherein an average thickness of the intermediate layer is 3.0 µm or more and 15.0 µm or less.

6. The coated cutting tool according to any one of claims 1 to 5, wherein an average thickness of the lower layer is 3.0 µm or more and 15.0 µm or less.

7. The coated cutting tool according to any one of claims 1 to 6, wherein the substrate is composed of any of a cemented carbide, a cermet, a ceramic or a cubic boron nitride sintered body.
